# EUROPÄISCHE PATENTSCHRIFT

(11) **EP 1 065 026 B1**
(45) Veröffentlichungstag und Bekanntmachung des Hinweises auf die Patenterteilung: **28.04.2004**
(21) Anmeldenummer: 99810487.1
(22) Anmeldetag: 03.06.1999
(51) Int. Cl.: B23P 15/04, B23P 6/00, F01D 5/28, C30B 13/00, C30B 33/00

(54) **Verfahren zur Herstellung oder zur Reparatur von Kühlkanälen in einstristallinen Komponenten von Gasturbinen**
Method for manufacturing or repairing cooling channels in single crystal gas turbine components
Procédé pour fabriquer ou réparer les canaux de refroidissement d' un élement monocristallin d' un turbine à gas

(43) Veröffentlichungstag der Anmeldung: 03.01.2001
(73) Patentinhaber: ALSTOM Technology Ltd, 5400 Baden (CH)
(72) Erfinder: Konter, Maxim, 5313 Klingnau (CH); Kurz, Wilfried, 1093 La Conversion (CH)

(56) Entgegenhaltungen:
- EP-A- 0 740 976
- EP-A- 0 892 090
- DE-A- 19 737 845
- US-A- 4 528 048
- US-A- 5 312 584
- US-A- 5 640 767
- US-A- 5 756 225
- US-A- 5 778 960

## Beschreibung

### TECHNISCHES GEBIET

Bei der Erfindung handelt es sich um ein Verfahren zur Herstellung oder zur Reparatur von Kühlkanälen in einkristallinen Komponenten von Gasturbinen.

### STAND DER TECHNIK

Es ist seit langem bekannt, mit Heissgas beaufschlagte Komponenten von Gasturbinen mit Kühlluftstrukturen zu versehen, um einerseits die Temperatur des Heissgases erhöhen zu können und andererseits die Lebensdauer der betroffenen Teile zu verlängern.
Üblicherweise werden diese Komponenten von Gasturbinen gegossen und bestehen aus einkristallinen Superlegierungen. Eine solche Superlegierung auf der Basis von Ni wird beispielsweise in der Patentschrift US 5,759,301 offenbart. Diese Legierung hat sich gerade bei sehr dünnen Wänden, wie sie bei Kühlkanälen in Komponenten von Gasturbinen vorkommen, bewährt, da sie keine Korngrenzen enthält. Korngrenzen würden sich negativ auf die Materialeigenschaften auswirken. Die Kühlkanäle können während des Giessens hergestellt werden, bekannt beispielsweise ist die Castcool-Technologie der Fa. Allison (siehe dazu: Burkholder et al., Allison engine testing CMSX-4 single crystal turbine blades and vanes, 3^{rd} International Charles Parsons Turbine Conference, ISSN 0-901716-89-8). Dieses Castcool-Gussverfahren arbeitet mit einem Keramikkern, welcher in die Gussform eingebaut wird. Dieses Verfahren ist aber leider relativ teuer, was sich durch die hohe Ausschussraten der Produktion der sehr dünnen Wände der Kühlkanäle erklären lässt. Es gibt auch insbesondere keine Möglichkeiten angeschlagene Komponenten mit diesem Verfahren zu reparieren.
Daneben sind andere Verfahren bekannt, um die Kühlkanäle herzustellen, darunter das LIGA-Verfahren (siehe dazu: "The Miniaturization Technologies-Past, Present and Futur", Frazier et al., from IEEE Transactions on industrial electronics, 1995, V42, n5 (Oct.), p. 423-430, ISSN 0278-0046) und lasergestützte Verfahren wie die LENS-Technik (Laser Engineered net Shaping). Sie werden aber in der Praxis nicht für die Herstellung von Kühlkanälen bei einkristallinen Strukturen eingesetzt, da bei der Produktion insbesondere durch die Temperatureinwirkung amorphe und multikristalline Strukturen entstehen, was die günstigen Eigenschaften der einkristallinen Strukturen in bezug auf die Festigkeit und die Duktilität zerstört und die sehr dünnen Wände von Gasturbinen eine erhöhte Anfälligkeit gegenüber den Belastungen, welchen sie ausgesetzt sind, aufweisen. Um diese Nachteile zu vermeiden wird eine einkristalline Struktur, welche keine Korngrenzen hat, benötigt.

Ein Verfahren zur Herstellung einer Kühlstruktur eines Tragflügels ist aus der Druckschrift US 5,640,767 bekannt. Dieses Verfahren weist aber den Nachteil auf, dass das Basismaterial und die zweite, aufgetragene Schicht aus unterschiedlichen Materialien bestehen. Dies führt zu einer Schwächung der Komponente an der Kontaktstelle zwischen den beiden Schichten.

Aus der Offenlegungsschrift EP 892 090 A1 ist hingegen ein Verfahren zur Herstellung von einkristallinen Strukturen bekannt. Dieses Verfahren arbeitet mit einem Energiestrahl hoher Energiedichte, wie zum Beispiel einem Laserstrahl, einem Elektrodenstrahl oder einem Lichtbogen, welcher ein Basismaterial aufschmilzt. Diesem geschmolzenen Bereich wird Material zugeführt, welches gleich dem Basismaterial ist oder welches eine ähnliche Kristallstruktur wie das Basismaterial aufweist, und ebenfalls aufgeschmolzen wird. Bei diesem Verfahren wird die Energiezufuhr so geregelt oder gesteuert, dass Erstarrungsgeschwindigkeit und Temperaturgradient zu einer gerichteten, dendrisch kristallinen und keiner globulitischen Erstarrung führen.

Ein Verfahren zur Reparatur einer einkristallinen Struktur ist auch aus EP 740 976 A1 bekannt.

### DARSTELLUNG DER ERFINDUNG

Es ist Aufgabe dieser Erfindung, ein Verfahren zu schaffen, mit welcher es vereinfacht möglich ist, die Kühlkanäle einer aus einkristallinen Strukturen bestehenden Gasturbinenkomponente herzustellen oder zu reparieren. Erfindungsgemäss wird dies bei einem Verfahren gemäss dem Oberbegriff des Anspruchs 1 dadurch erreicht, dass die einkristallinen Gasturbinenkomponente gegossen wird, thermisch stabiles Füllmaterial aufgetragen wird, eine Einkristallschicht oberhalb des thermischen stabilen Füllmaterials epitaktisch geschaffen wird und das thermisch stabile Füllmaterial entfernt wird.

Vorteilhaft ist es mit dem erfindungsgemässen Verfahren vereinfacht möglich, Gasturbinenkomponenten mit Kühlkanälen herzustellen. Beispielsweise durch Ätzen kann das thermisch stabile Füllmaterial leicht entfernt werden. Die Ausschussrate des Verfahrens und damit die verbundenen Kosten sind vorteilhaft gering im Vergleich mit der aus dem Stand der Technik bekannten Castcool-Technologie. Das Verfahren ist auch mehrfach nacheinander anwendbar, um übereinanderliegende Kühlkanäle herzustellen. Auch ist es mit diesem Verfahren möglich, die Kühlkanäle einer angeschlagenen Gasturbinenkomponente zu reparieren.

Die weiteren vorteilhaften Ausführungsformen sind Gegenstand der abhängigen Ansprüche.

### KURZE BESCHREIBUNG DER ZEICHNUNGEN

Es zeigen:
- **Fig. 1**: eine gegossene Gasturbinenkomponente aus einer einkristallinen Struktur, mit einem vorgefertigten Profil für die Kühlkanäle,
- **Fig. 2**: die gegossene Gasturbinenkomponente mit einer keramischen Schicht oberhalb des vorgefertigten Profils für die Kühlkanäle,
- **Fig. 2a**: die gegossene Gasturbinenkomponente mit einer keramischen Schicht oberhalb des vorgefertigten, runden Profils für die Kühlkanäle,
- **Fig. 3**: die gegossene Gasturbinenkomponente mit einer keramischen Schicht oberhalb des vorgefertigten Profils für die Kühlkanäle, nach Entfernen des überflüssigen Materials,
- **Fig. 3a**: eine Variation von Figur 3, mit einem veränderten, runden Profil für die Kühlkanäle,
- **Fig. 4**: Epitaktisches Aufbringen einer weiteren Schicht auf die Gasturbinenkomponente mit Hilfe eines Lasers und eines Pulvers, oberhalb des mit der keramischen Schicht maskierten Materials,
- **Fig. 5**: fertige Gasturbinenkomponente, wobei die Kühlkanäle noch mit der keramischen Schicht maskiert sind,
- **Fig. 6**: fertige Gasturbinenkomponente, wobei die Kühlkanäle nicht mehr mit der keramischen Schicht maskiert sind, und mehrere Kühlkanäle übereinander durch mehrfaches Anwenden des erfindungsgemässen Verfahrens angebracht wurden,
- **Fig. 7**: gegossene Gasturbinenkomponente ohne vorgefertigtes Profil für die Kühlkanäle,
- **Fig. 8**: gegossene Gasturbinenkomponente mit angebrachten Rippen aus einem keramischen Material und das epitaktische Aufbringen einer weiteren Schicht auf die Gasturbinenkomponente mit Hilfe eines Lasers und eines Pulvers, oberhalb der mit den keramischen Rippen maskierten Gasturbinenkomponente,
- **Fig. 9**: fertige Gasturbinenkomponente, wobei die Kühlkanäle noch mit dem keramischen Material maskiert sind, und
- **Fig. 10**: einen Querschnitt durch eine Turbinenschaufel mit Hohlraum und integrierten Kühlkanälen.

Es werden nur die für die Erfindung wesentlichen Elemente dargestellt.

### WEG ZUR AUSFÜHRUNG DER ERFINDUNG

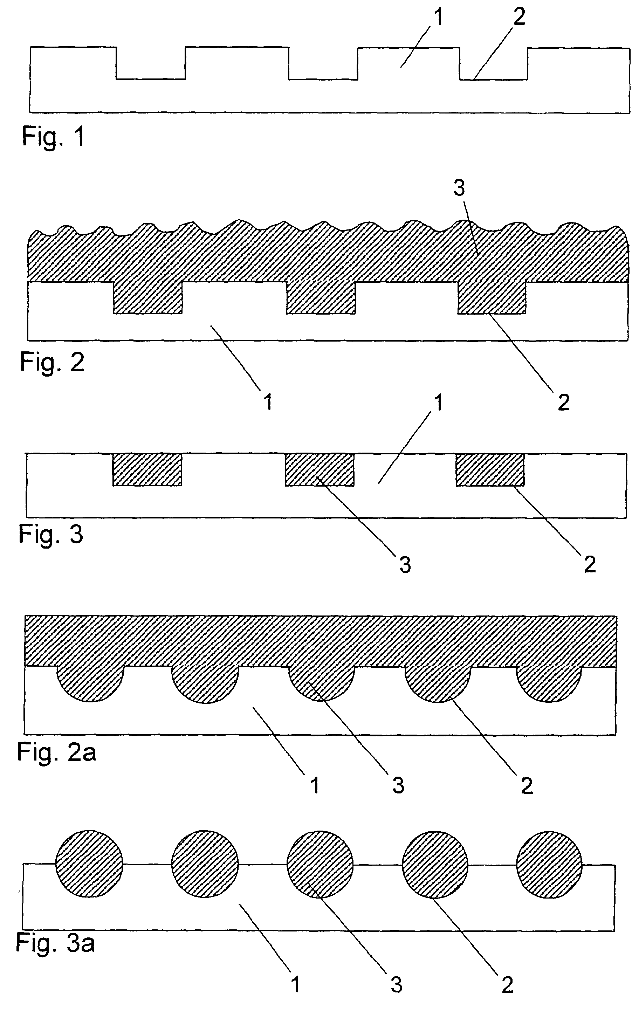

Die Figur 1 zeigt eine aus einer einkristallinen Struktur gegossene Gasturbinenkomponente 1. Diese Gasturbinenkomponente 1 weist ein Profil 2 auf, welches später als Kühlluftstruktur der Komponente 1 dient. Dieses Profil 2 kann beim Giessen entstanden sein, aber auch eine spätere maschinelle Bearbeitung ist möglich.

In der Figur 2 ist die Gasturbinenkomponente 1 mit dem Profil 2 mit einem thermisch stabilen Füllmaterial 3 in Form einer weiteren Schicht überzogen. Das thermisch stabile Füllmaterial 3 dient zur Maskierung des Profils 2. Es kann sich dabei beispielsweise um ein keramisches Material auf der Basis von Al₂O₃ und/oder SiO₂ und/oder ZrO₂ handeln. In diesem dargestellten Ausführungsbeispiels handelt es sich zur besseren Verteilbarkeit auf der Gasturbinenkomponente 1 und insbesondere im Profil 2 um einen Schlicker, also ein keramisches Material, welches noch H₂O enthält.

In der Figur 3 ist überflüssiges thermisch stabiles Füllmaterial 3 oberhalb des Profils 2 entfernt worden, so dass nur noch das Profil 2 maskiert ist. Zwischen den Figuren 2 und 3 ist die Gasturbinenkomponente 1 mit der keramischen Schicht getrocknet worden, um den Schlickers zu trocknen, und so zu einer ausreichenden Festigkeit des Schlickers zu gelangen.

Wie in den Figur 2a und 3a dargestellt, ist es selbstverständlich auch denkbar, andersartige Formen des Profils 2 für die Kühlluftstrukturen zu erzeugen. Beispielsweise ist in den Figuren 2a und 3a das Profil 2 rund ausgearbeitet und auch die Maskierung mit dem thermisch stabilen Füllmaterial 3 erfolgt in runder Form. Andere Formen sind ebenso denkbar.

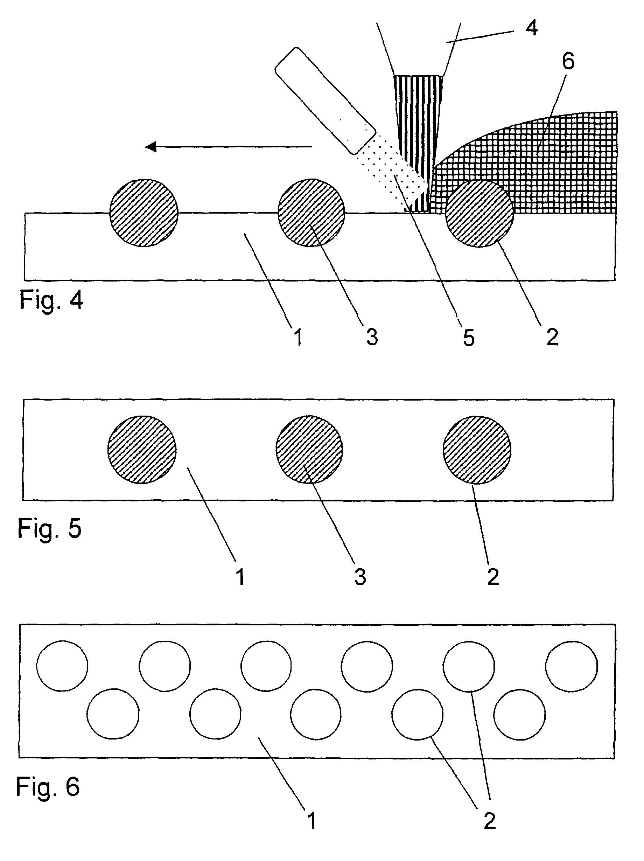

Die Figur 4 zeigt, wie oberhalb des Profils 3, welches mit dem thermisch stabilen Füllmaterial 3 maskiert ist, eine weitere, einkristalline Schicht 6 mit Hilfe einer Energiequelle, im Ausführungsbeispiel wird ein Laser 4 verwendet, und mit zusätzlichem Material, beispielsweise einem Pulver 5, entsteht. Die Wachstumsrichtung der einkristalline Schicht 6 ist mit einem Pfeil angedeutet. Solche Verfahren sind beispielsweise aus den europäischen Offenlegungsschriften EP 892 090 A1 oder EP 0740 976 A1 bekannt, es sind aber auch gleichwertige Verfahren anwendbar. Als Puder 5 kann das Material der Superlegierung, aus welcher die Gasturbinenkomponente 1 besteht, verwendet werden. Beispielsweise kann es sich dabei um eine MK4-Turbinenschaufel handeln mit einer in Tabelle 1 angegebenen Zusammensetzung. Denkbar ist auch eine MK-4-Turbinenschaufel und einer SV-20 Zusammensetzung als epitaktische, einkristalline Schicht 6, welche in diesem Fall gleichzeitig als Schutzschicht dient.

Die Zusammensetzung von MK-4 bzw. SV-20 (Angaben in Gew.%)

**Tab. 1**

| | Ni | Cr | Co | Mo | W | Re | Al | Si | Ta | Ti | C | B | Y |
|---|---|---|---|---|---|---|---|---|---|---|---|---|---|
| MK-4 | Rest | 6.5 | 9 | 0.6 | 6.5 | 3 | 5.6 | -- | 6.6 | 1 | 0.03 | 0.005 | -- |
| SV-20 | Rest | 25 | -- | -- | -- | -- | 5.5 | 3 | 1 | -- | -- | -- | 0.5 |

Die Figur 5 zeigt die gefertigte Gasturbinenkomponente 1, auf welcher oberhalb des Profils 2 die neue, einkristalline Schicht 6 entstanden ist. Die Kühlkanäle sind noch mit dem thermisch stabilen Füllmaterial 3 maskiert.

Es ist möglich, das erfindungsgemässe Verfahren mehrfach hintereinander durchzuführen und so mehrere Schichten übereinander mit einem Kühlprofil zu erzeugen. Dies wird beispielsweise in der Figur 6 dargestellt. Das die Kühlkanäle maskierende, thermisch stabile Füllmaterial 3 wurde durch einen nicht dargestellten, weiteren Verfahrensschritt beispielsweise durch Ätzen oder andere, gleichwertige Verfahren entfernt.

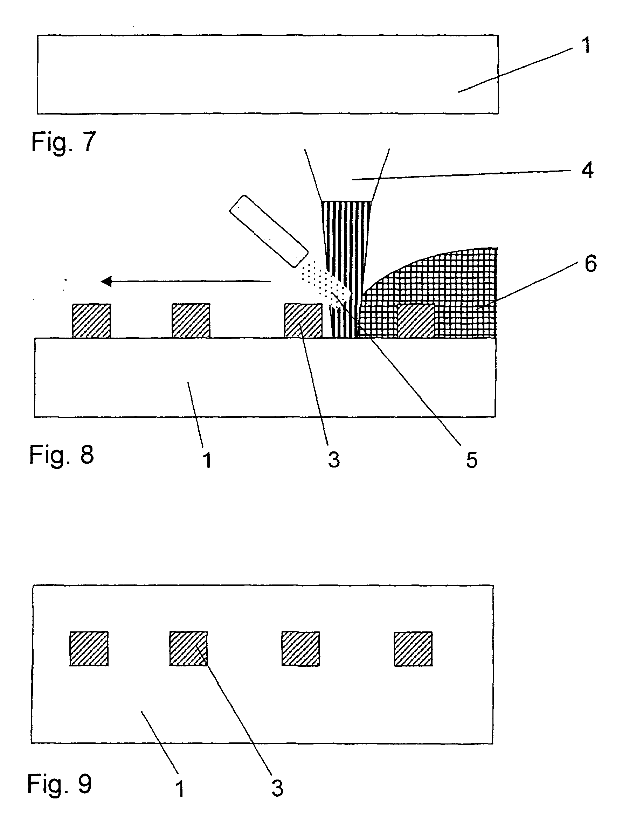

Eine weitere Möglichkeit die Kühlkanäle einer Gasturbinenkomponente 1 zu erstellen wird in den Figuren 7 bis 9 dargestellt. Eine in der Figur 7 dargestellte Gasturbinenkomponente 1 enthält in diesem Fall noch kein Profil für die Kühlkanäle. In der Figur 8 wird ein thermisch stabiles Füllmaterial 3 auf die Stellen der Gasturbinenkomponente 1 gelegt, welche später als Kühlkanäle dienen sollen. Auch in diesem Fall besteht das thermisch stabile Füllmaterial 3 aus einem keramischen Material, beispielsweise auf der Basis von Al₂O₃ und/oder SiO₂ und/oder ZrO₂, es enthält aber kein H₂O und wird dadurch wesentlich fester. Mit einem bekannten Verfahren wird wieder eine epitaktische, einkristalline Schicht 6 durch eine Energiequelle, beispielsweise durch einen Laser 4, und durch zusätzliches Material, beispielsweise ein Pulver 5, oberhalb der Gasturbinenkomponente 1 und des thermisch stabilen Füllmaterials 3 erzeugt. Die fertige Gasturbinenkomponente 1 ist in der Figur 9 dargestellt, das thermisch stabile Füllmaterial 3 ist allerdings noch nicht entfernt worden. Das thermisch stabile Füllmaterial 3 wird wieder durch Ätzen oder gleichwertige Verfahren entfernt.

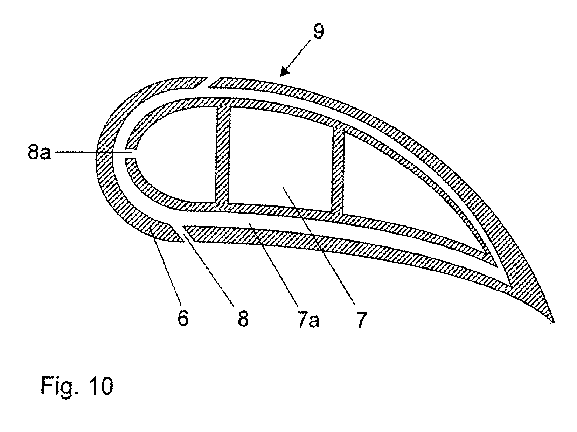

In der Figur 10 ist ein Schnitt durch eine einkristalline Turbinenschaufel 9 als ein Beispiel für eine Gasturbinenkomponente dargestellt. Die Turbinenschaufel 9 besteht aus einem Basismaterial (beispielsweise MK-4) und kann mit einer Schutzschicht überzogen sein. Sie enthält ein Kühlsystem, welches aus einem Hohlraum 7 und aus inneren Kühlkanälen 7a besteht. Die Kühlkanäle 7a sind über Verbindungslöcher 8a mit dem Hohlraum 7 und über Verbindungslöcher 8 nach aussen verbunden. Die in der Figur 10 dargestellte Anzahl der Verbindungslöcher 8,8a ist nur beispielsweise und hängt von der jeweiligen Ausführungsform der Turbinenschaufel 9 ab. Um die Verbindungslöcher 8,8a bei der Produktion herzustellen ist nach dem Giessen noch eine Bohrung notwendig, da beim Giessprozess lediglich die inneren Kühlkanäle 7a entstehen. Die einkristalline Schicht 6, welche um die Kühlkanäle 7a epitaktisch geschaffen wurde, besteht, wie bereits beschrieben, aus dem Grundmaterial der Turbinenschaufel 9 oder aus einer Schutzschicht, beispielsweise SV-20. Die Kühlkänale 7a und die Verbindungslöcher 8a wurden bei dem epitaktischen Herstellen der weiteren, einkristallinen Schicht 6 mit einem thermische stabilen Füllmaterial 3 maskiert.

Selbstverständlich bleiben allen weiteren Produktionsschritte wie beispielsweise das Aufbringen einer thermischen Schutzschicht auf die fertige Gasturbinenkomponente aus TBC (thermal barrier coating, Y stabilisiertes Zr-Oxid), aus MCrAIY oder ähnlichem und standardmässige Endkontrollen bezüglich der Qualitätssicherstellung erhalten.

Das erfindungsgemässe Verfahren ist auch geeignet, um das Kühlsystem einer angeschlagenen Gasturbinenkomponente zu reparieren.

### BEZUGSZEICHENLISTE

- **1**: Gasturbinenkomponente, gegossen
- **2**: Profil
- **3**: Thermisch stabiles Füllmaterial
- **4**: Laser
- **5**: Pulver
- **6**: Epitaktische, einkristaline Schicht
- **7**: Hohlraum
- **7a**: Kühlsystem
- **8,8a**: Verbindungslöcher
- **9**: Turbinenschaufel

## Patentansprüche

1. Verfahren zur Herstellung oder Reparatur von Kühlkanälen (7a) in einkristallinen Gasturbinenkomponenten (1),
**dadurch gekennzeichnet, dass**
a. die einkristalline Gasturbinenkomponente (1) gegossen wird,
b. thermisch stabiles Füllmaterial (3) aufgetragen wird,
c. eine Einkristallschicht (6) oberhalb des thermischen stabilen Füllmaterials (3) epitaktisch geschaffen wird und
d. das thermisch stabile Füllmaterial (3) entfernt wird.

2. Verfahren nach Anspruch 1,
**dadurch gekennzeichnet, dass**
ein Profil (2) der Kühlkanäle (7a) an der Gasturbinenkomponente (1) während des Giessvorgangs oder durch spätere maschinelle Bearbeitung gebildet wird.

3. Verfahren nach Anspruch 1,
**dadurch gekennzeichnet, dass**
zwischen dem Giessen der einkristallen Gasturbinenkomponente (1) und dem Auftragen des thermisch stabilen Füllmaterials (3) Verbindungslöcher (8,8a) gebohrt werden, welche die Kühlkanäle (7a) durch die Wände der einkristallinen Gasturbinenkomponente (1) nach aussen oder zu einem Hohlraum (7) der Gasturbinenkomponente (1) verbinden.

4. Verfahren nach Anspruch 1,
**dadurch gekennzeichnet, dass**
als thermisch stabiles Füllmaterial (3) ein keramisches Material bzw. ein Schlicker verwendet wird.

5. Verfahren nach Anspruch 4,
**dadurch gekennzeichnet, dass**
nach dem Auftragen des keramischen Materials bzw. des Schlickers die Gasturbinenkomponente (1) einschliesslich dem aufgetragenen keramischen Material bzw. dem Schlicker getrocknet wird und überflüssiges keramische Material bzw. Schlicker entfernt wird.

6. Verfahren nach einem der Ansprüche 1-5,
**dadurch gekennzeichnet, dass**
weitere Einkristallschichten (6) durch Wiederholung der Verfahrensschritte b), c) und d) des Anspruchs 1 aufgetragen werden.

7. Verfahren nach einem der Ansprüche 1-6,
**dadurch gekennzeichnet, dass**
das thermisch stabile Füllmaterial (3) durch Ätzen entfernt wird.

## Claims

1. Process for producing or repairing cooling passages (7a) in single crystal gas turbine components (1), **characterized in that**
a. the single crystal gas turbine component (1) is cast,
b. thermally stable filling material (3) is applied,
c. a single crystal layer (6) is created epitaxially above the thermally stable filling material (3), and
d. the thermally stable filling material (3) is removed.

2. Process according to Claim 1, **characterized in that** a profile (2) of the cooling passages (7a) is formed on the gas turbine component (1) during the casting operation or by subsequent machining.

3. Process according to Claim 1, **characterized in that** connecting holes (8, 8a), which connect the cooling passages (7a) through the walls of the single crystal gas turbine component (1) to the outside or to a cavity (7) in the gas turbine component (1), are drilled between the casting of the single crystal gas turbine component (1) and the application of the thermally stable filling material (3).

4. Process according to Claim 1, **characterized in that** a ceramic material or a slip is used as the thermally stable filling material (3).

5. Process according to Claim 4, **characterized in that** after the ceramic material or slip has been applied, the gas turbine component (1), including the applied ceramic material or slip, is dried and excess ceramic material or slip is removed.

6. Process according to one of Claims 1-5, **characterized in that** further single crystal layers (6) are applied by repeating process steps b), c) and d) of Claim 1.

7. Process according to one of Claims 1-6, **characterized in that** the thermally stable filling material (3) is removed by etching.

## Revendications

1. Procédé pour fabriquer ou réparer des canaux de refroidissement (7a) dans des composants monocristallins (1) de turbines à gaz,
**caractérisé en ce que**
a. le composant monocristallin (1) de turbine à gaz est coulé,
b. l'on applique un matériau de remplissage (3) thermiquement stable,
c. une couche monocristalline (6) est formée par épitaxie au-dessus du matériau de remplissage (3) thermiquement stable et
d. le matériau de remplissage (3) thermiquement stable est enlevé.

2. Procédé selon la revendication 1,
**caractérisé en ce**
**qu'**un profil (2) des canaux de refroidissement (7a) est formé sur le composant (1) de turbine à gaz pendant l'opération de coulée ou par usinage en machine ultérieur.

3. Procédé selon la revendication 1,
**caractérisé en ce que**
l'on perce des trous de connexion (8, 8a) entre la coulée du composant monocristallin (1) de turbine à gaz et l'application du matériau de remplissage (3) thermiquement stable, lesquels connectent les canaux de refroidissement (7a) à travers les parois du composant monocristallin (1) de turbine à gaz vers l'extérieur ou vers un espace creux (7) du composant (1) de turbine à gaz.

4. Procédé selon la revendication 1,
**caractérisé en ce que**
l'on utilise comme matériau de remplissage (3) thermiquement stable un matériau céramique ou de la barbotine.

5. Procédé selon la revendication 4,
**caractérisé en ce**
**qu'**après l'application du matériau céramique ou de la barbotine, le composant (1) de turbine à gaz y compris le matériau céramique ou la barbotine appliqué(e) est séché et le matériau céramique ou la barbotine en excès est enlevé(e).

6. Procédé selon l'une quelconque des revendications 1 à 5,
**caractérisé en ce que**
d'autres couches monocristallines (6) sont appliquées en répétant les étapes de procédé b), c) et d) de la revendication 1.

7. Procédé selon l'une quelconque des revendications 1 à 6,
**caractérisé en ce que**
le matériau de remplissage (3) thermiquement stable est enlevé par attaque chimique.
